# EUROPEAN PATENT APPLICATION

(11) **EP 4 749 839 A1**
(43) Date of publication of application: **27.05.2026**
(21) Application number: 24881998.9
(22) Date of filing: 21.08.2024
(51) Int. Cl.: H01R 13/52

(54) **CONNECTOR UNIT**

(30) Priority: 23.10.2023 JP 2023181731; 23.10.2023 JP 2023181732
(71) Applicant: Japan Aviation Electronics Industry, Limited, Tokyo 150-0043 (JP); Yamaha Hatsudoki Kabushiki Kaisha, Iwata-shi, Shizuoka 438-8501 (JP)
(72) Inventor: NAKAMURA, Kazunobu, Tokyo 150-0043 (JP); IWAO, Naoki, Tokyo 150-0043 (JP); KASAI, Yuki, Tokyo 150-0043 (JP); ISHIHARA, Shuhei, Iwata-shi, Shizuoka 438-8501 (JP)
(74) Representative: MERH-IP Matias Erny Reichl Hoffmann Patentanwälte PartG mbB
(86) International application number: PCT/JP2024/029552
(87) International publication number: WO 2025/088881

(57) **Abstract**

An object of the present invention is to provide a connector unit that can cause water guided from inside of an appliance to a drain hole to be actively discharged without increasing a risk of intrusion of foreign matters into an interior, and that can prevent intrusion of foreign matters into the interior in a predetermined case. A connector unit (100) includes a case (70), an inside of which is separated into a waterproof region and a non-waterproof region, an interface connector (40) mounted in the non-waterproof region, an opening part (73) provided on a non-waterproof region side, the opening part allowing insertion/removal of a mating connector, a drain hole part (76) provided on the non-waterproof region side, the drain hole part having a first hole shape penetrating from an inner side to an outer side of the case (70) so as to allow water received in the interface connector (40) to be discharged, a cutout part (761) cutting out a predetermined range of a circumference of the first hole shape of the drain hole part (76), the cutout part extending from a mid-point in a penetration direction to the outer side of the case (70), and a waterproof cap (200) that is unitarily formed in a manner capable of covering the opening part (73), the drain hole part (76), and the cutout part (761) from outside the case (70).

## Description

### [TECHNICAL FIELD]

The present invention relates to a structure of a connector unit for water discharge and foreign matter intrusion prevention.

### [BACKGROUND ART]

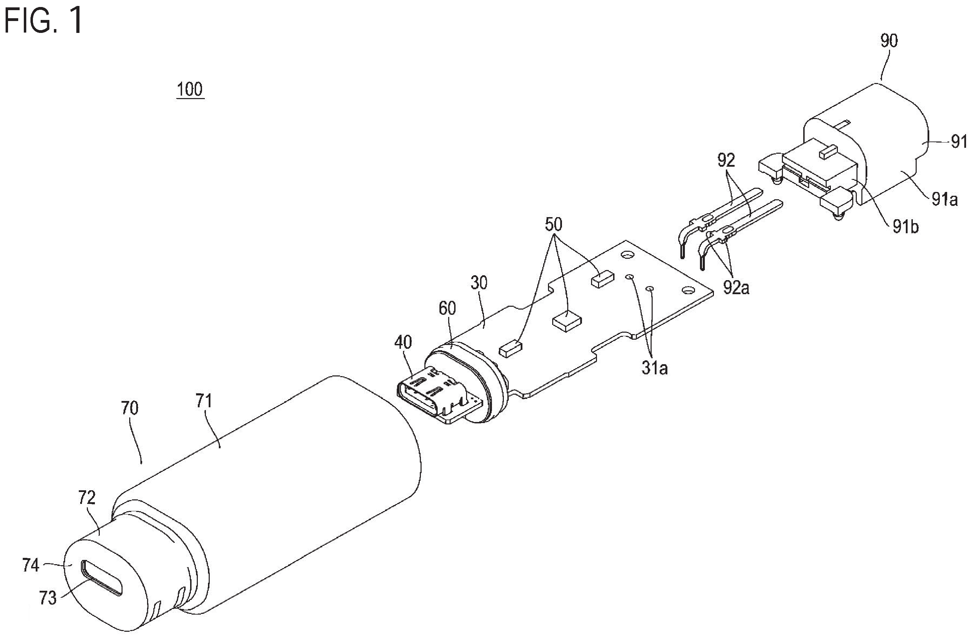

As a conventional art related to a connector unit having a drainage structure, there is one that is capable of discharging water inside to outside even when water enters inside an appliance (for example, see Patent Literature 1). FIG. 1 is a diagram of a drainage structure of a connector unit of a conventional art. A connector unit 100 in FIG. 1 includes a flat plate-shaped printed wiring board 30 including a first region 30a and a second region 30b, an interface connector 40 having a non-watertight structure and mounted on the first region 30a, a waterproof sealing member 60 that covers a boundary 30c, and a case including an opening part 73, the case being for housing the printed wiring board 30, the interface connector 40, and the waterproof sealing member 60. The waterproof sealing member 60 separates inside of the case 70 into the first region 30a side and the second region 30b side. The second region 30b side inside the case 70 is a waterproof region. On the first region 30a side of the case 70, two drain holes 76 are formed on each of left and right lower sides across a front plate part 74.

### [PRIOR ART LITERATURE]

### [PATENT LITERATURE]

[Patent literature 1]: Japanese Patent No. 7297994

### [SUMMARY OF THE INVENTION]

### [PROBLEMS TO BE SOLVED BY THE INVENTION]

However, depending on the size or arranged position of the drain hole, water that should be discharged may get stuck (trapped) near a discharge outlet of the drain hole. A phenomenon where drainage is trapped (hereinafter referred to also as "trapping phenomenon") is where drainage from the drain hole is suppressed and water stays inside the case. This may cause components made of metal (hereinafter referred to also as "metal component(s)") such as a connector to rust.

If the drain hole is made larger to prevent the trapping phenomenon, water drops may possibly be prevented from getting stuck. However, if a larger drain hole is formed, there is a problem that foreign matters are more likely to enter inside the appliance.

In view of the above problem, the present invention is aimed at providing a connector unit that can cause water guided from inside of an appliance to a drain hole to be actively discharged without increasing a risk of intrusion of foreign matters into an interior, and that can prevent intrusion of foreign matters into the interior in a predetermined case.

### [MEANS TO SOLVE THE PROBLEMS]

To solve the problem described above, a connector unit according to the present embodiment comprises: a case, an inside of which is separated into a waterproof region and a non-waterproof region; a metal component mounted in the non-waterproof region of the case; an opening part provided on a non-waterproof region side of the case, the opening part allowing insertion/removal of a mating connector; a drain hole part provided on the non-waterproof region side of the case, the drain hole part having a first hole shape penetrating from an inner side to an outer side of the case so as to allow water received in the metal component to be discharged; a cutout part cutting out a predetermined range of a circumference of the first hole shape of the drain hole, the cutout part extending from a mid-point in a penetration direction to the outer side of the case; and a waterproof cap that is unitarily formed in a manner capable of covering the opening part, the drain hole part, and the cutout part from outside the case.

### [EFFECTS OF THE INVENTION]

The connector unit of the present disclosure includes the cutout part cutting out a predetermined range of the circumference of the first hole shape of the drain hole, the cutout part extending from a mid-point in the penetration direction to the outer side of the case. When the cutout part is provided, a diameter of liquid drop from water that is retained can be increased and the liquid drop can more easily drop compared to a case where the cutout part is not provided, and thus, water entering the drain hole can be actively discharged inside an appliance without increasing the risk of intrusion of foreign matters into the appliance. Moreover, the connector unit of the present disclosure includes the waterproof cap that is unitarily formed in a manner capable of covering the opening part, the drain hole part, and the cutout part from outside the case. Accordingly, when the waterproof cap is attached, foreign matters can be prevented from entering the case.

### [BRIEF DESCRIPTION OF THE DRAWINGS]

[FIG. 1] FIG. 1 is a diagram of a drainage structure of a connector unit of a conventional art;
[FIG. 2] FIG. 2 is a diagram showing an example of a connector unit according to a present embodiment. (a) is a perspective view, (b) is a side view, and (c) is a front view;
[FIG. 3] FIG. 3 is a diagram showing an example where a waterproof cap not shown in FIG. 2 is shown in relation to a connector unit 100 shown in FIG. 2. (a) is a perspective view, (b) is a side view, and (c) is a front view;
[FIG. 4] FIG. 4 is a diagram for describing inside of the connector unit 100. (a) is a rear view, and (b) is an F-F cross-sectional view of (a);
[FIG. 5] FIG. 5 is an exploded perspective view of the connector unit 100;
[FIG. 6] FIG. 6 is an exploded perspective view of the connector unit 100;
[FIG. 7] FIG. 7 is a diagram showing a printed circuit board 35. (a) is a perspective view, and (b) is a side view of a printed wiring board 30 shown in (a);
[FIG. 8] FIG. 8 is a diagram showing the printed circuit board 35 where a waterproof sealing member 60 is integrally formed. (a) is a perspective view, and (b) is a cross-sectional view seen from an interface connector 40 side, where the cross-sectional view is taken along a surface including a boundary 30c shown in (a) of FIG. 7;
[FIG. 9] FIG. 9 is a diagram showing an example of the connector unit where a rear cover 80 is included. (a) is a rear view, and (b) is a G-G cross-sectional view of (a);
[FIG. 10] FIG. 10 is a diagram for describing a water guide member 28. (a) is a diagram showing a part corresponding to a first region 30a of a cylindrical part 72 in a B-B cross-sectional view of (c) of FIG. 2, (b) is an H-H cross-sectional view of (a), and (c) is a perspective view showing (b) from an upper left side;
[FIG. 11] FIG. 11 is an enlarged view of a region Q in (a) of FIG. 10;
[FIG. 12] FIG. 12 is a schematic view for describing drain hole parts 76₁, 76₂ and a cutout part 761 according to a first embodiment. (a) is a side view of a region corresponding to the cylindrical part 72 of the connector unit 100, and (b) is a W-W cross-sectional view of (a);
[FIG. 13] FIG. 13 is a schematic view showing an example of an impact of drainage due to presence of the cutout part 761. (a) is a case where the cutout part 761 is not provided, and (b) is a case where the cutout part 761 is provided;
[FIG. 14] FIG. 14 is a diagram showing a structure of a waterproof cap 200. (a) is a perspective view seen from a peripheral cap 220 side, and (b) is a rear view seen from the peripheral cap 220 side;
[FIG. 15] FIG. 15 is a diagram showing a periphery of the cylindrical part 72 of the connector unit 100 where the waterproof cap 200 is attached. (a) is a diagram showing the waterproof cap 200 in relation to (b) of FIG. 4, and (b) is an enlarged view of a region X in (a);
[FIG. 16] FIG. 16 is a diagram for describing a drain hole and a cutout part according to a modification of the first embodiment, and (a) is a schematic view showing a periphery of the drain hole part 76₁ and the drain hole part 76₂ in (a) of FIG. 12, and (b) to (f) are schematic views showing the drain holes and the cutout parts according to the modification in the same manner as in (a); and
[FIG. 17] FIG. 17 is a diagram for describing a drain hole and a cutout part according to a second embodiment. (a) is a schematic view shown in the same manner as in (a) of FIG. 16, (b) is a diagram extracting and showing the drain hole parts 76₁, 76₂ in (a), (c) is a U-U cross-sectional view of (a), and (d) is a V-V cross-sectional view of (a).

### [DETAILED DESCRIPTION OF THE EMBODIMENTS]

### <First Embodiment>

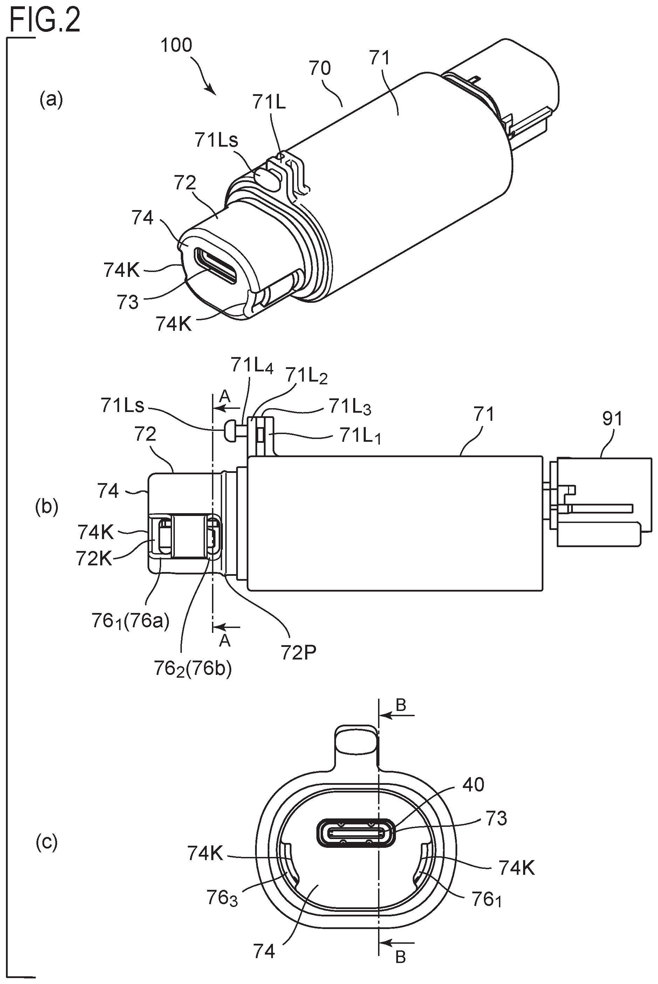

Hereinafter, a connector unit according to a first embodiment of the present invention will be described with reference to the drawings. In the following description, structural parts having the same function will be denoted by a same number, and a redundant description will be omitted. Additionally, FIGS. 2 to 17 described below include reference signs that are the same as reference signs described in relation to a conventional art in FIG. 1, but FIGS. 2 to 17 are different from FIG. 1.

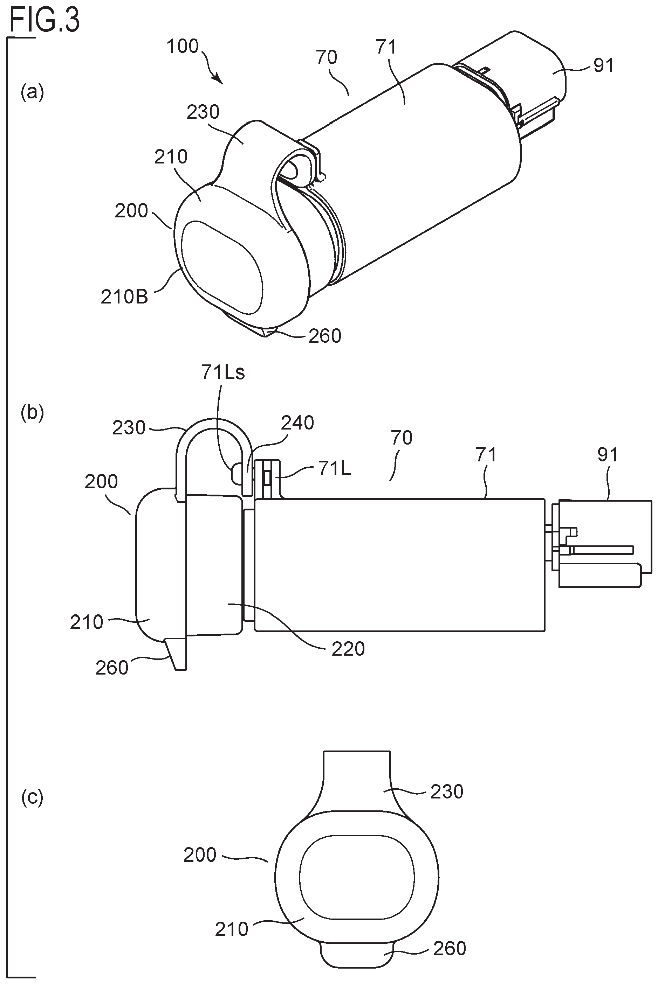

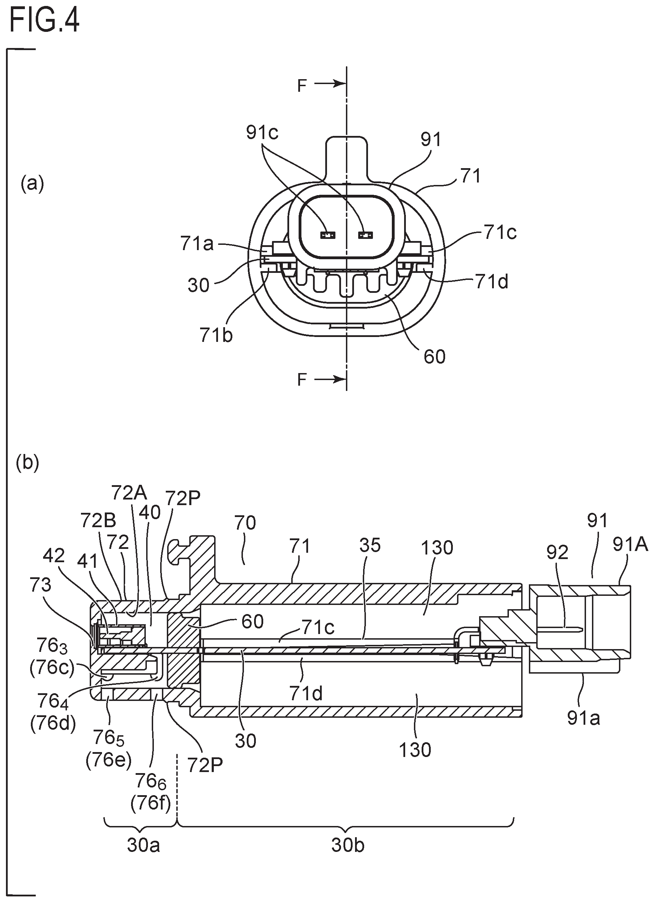

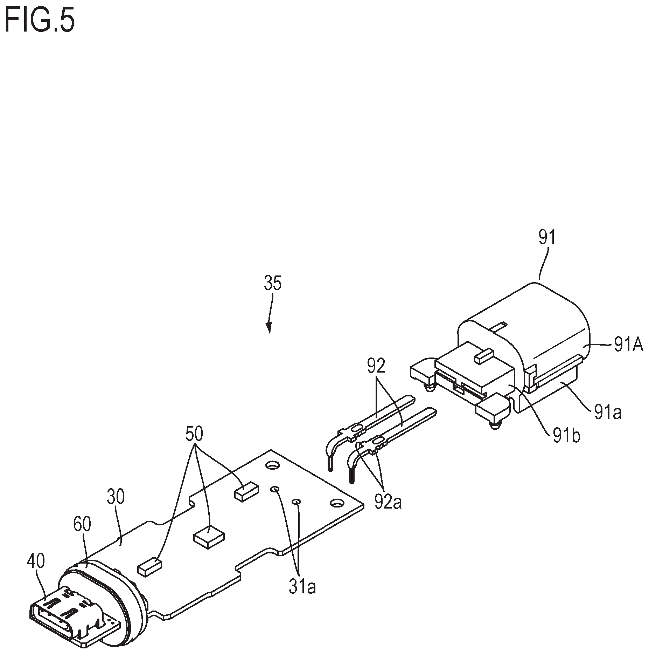

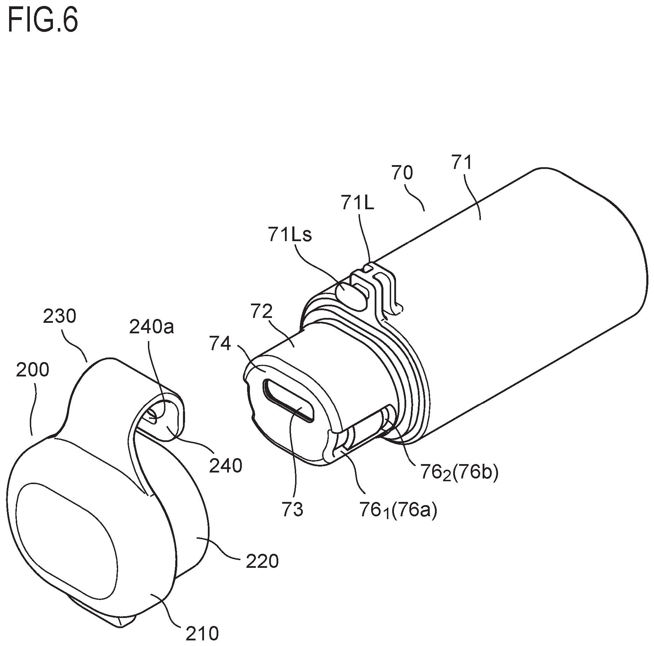

FIG. 2 is a diagram showing an example of the connector unit according to the present embodiment. (a) is a perspective view, (b) is a side view, and (c) is a front view. FIG. 2 does not show a waterproof cap 200, which is one of structural elements of a connector unit 100. FIG. 3 is a diagram showing an example where a waterproof cap not shown in FIG. 2 is shown in relation to the connector unit 100 shown in FIG. 2. (a) is a perspective view, (b) is a side view, and (c) is a front view. FIG. 4 is a diagram for describing inside of the connector unit 100. (a) is a rear view, and (b) is an F-F cross-sectional view of (a). FIG. 5 is an exploded perspective view of the connector unit 100. FIG. 6 is an exploded perspective view of the connector unit 100. Additionally, in (a) of FIG. 4, potting resin 130 described later is not shown, and in (b) of FIG. 4, an electronic component 50 is not shown.

As shown in FIGS. 5 and 6, the connector unit 100 according to the present embodiment is configured by including, as main elements, a printed wiring board 30, an interface connector 40, electronic components 50, a waterproof sealing member 60, a case 70, a rear connector 91, and a waterproof cap 200.

### (Printed Wiring Board 30)

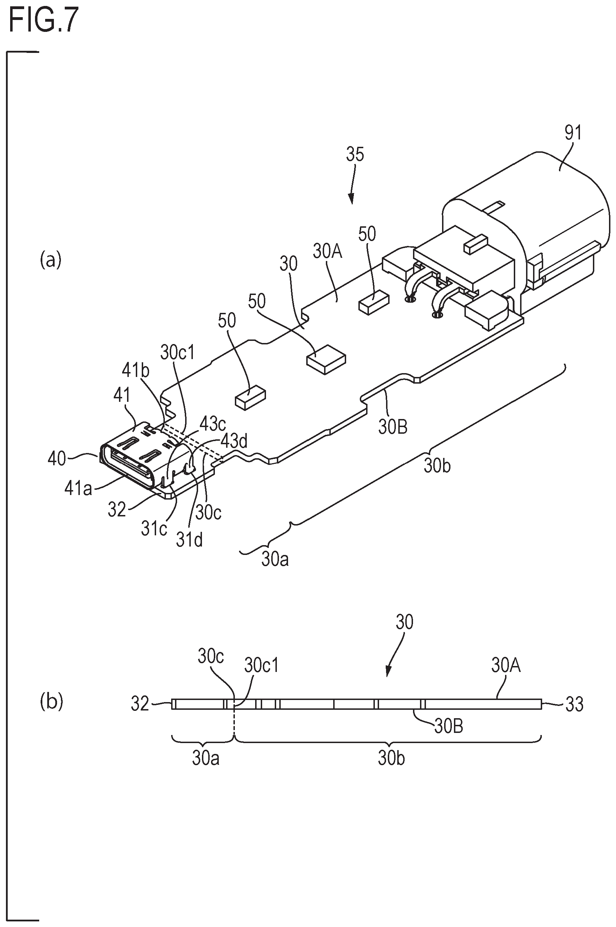

The printed wiring board 30 is a single- or multi-layer wiring board made mainly of glass epoxy resin, for example. FIG. 7 is a diagram showing a printed circuit board 35. (a) is a perspective view, and (b) is a side view of the printed wiring board 30 shown in (a).

As shown in FIG. 7, the printed wiring board 30 according to the present embodiment has a flat plate shape including an upper surface 30A having a substantially rectangular shape and a lower surface 30B that faces the upper surface 30A, and includes an end part 32 including an end surface corresponding to one end in a length direction and an end part 33 including an end surface on an opposite side from the end part 32. The printed wiring board 30 includes a first region 30a that extends from the end part 32 in a direction toward the end part 33, and a second region 30b that is adjacent to the first region 30a and that extends to the end part 33. When a surface at a boundary between the first region 30a and the second region 30b is defined as a boundary 30c, the first region 30a is a region, of the printed wiring board 30, from the end part 32 to the boundary 30c, and the second region 30b is a region, of the printed wiring board 30, from the boundary 30c to the end part 33.

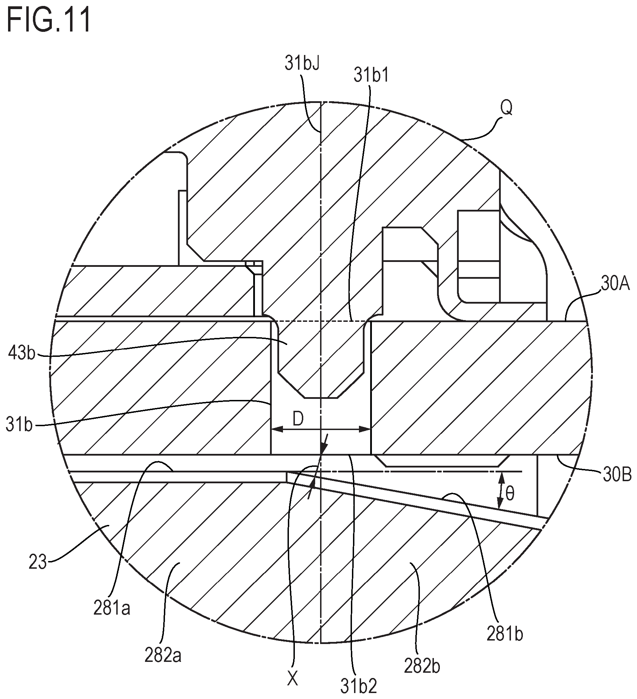

The interface connector 40, the electronic components 50, and the rear connector 91 are mounted on the upper surface 30A of the printed wiring board 30. In the present embodiment, the printed wiring board 30 where the interface connector 40, the electronic components 50, and the rear connector 91 are mounted is referred to as "printed circuit board 35". The printed circuit board 35 is housed inside the case 70. Additionally, the printed wiring board 30 includes two penetration holes 31b that are next to each other in a width direction (see one penetration hole 31b shown in FIG. 11). The penetration hole 31b has a circular hole, and includes two end parts, namely, an end part 31b1 on the upper surface 30A side, and an end part 31b2 on the lower surface 30B side.

### (Interface Connector 40)

The interface connector 40 to be connected to a connector of a smartphone, for example, is mounted on the upper surface 30A of the printed wiring board 30, on the end part 32 side of the first region 30a. The interface connector 40 is a type of electronic component. As shown in FIG. 7, a terminal 42 of the interface connector 40 is covered by a shell 41 that is made of metal and that has a non-watertight structure, and the terminal 42 is positioned facing outside of the case 70 through an opening part 73 provided in a front plate part 74 of the case 70 (FIG. 6). The shell 41 includes a first end part 41a and a second end part 41b. The interface connector 40 includes two protruding parts 43b (see one protruding part 43b shown in FIG. 11) on a bottom surface on the end part 41b side, and two protruding parts 43c, 43d ((a) of FIG. 7) on both side surfaces of the shell 41, the two protruding parts 43c, 43d being provided in this order from the end part 41a side. The protruding part 43b is inserted in the penetration hole 31b (FIG. 11) provided in the printed wiring board 30. In the same manner, the protruding parts 43c, 43d are inserted in penetration holes 31c, 31d, respectively. When the protruding parts 43b, 43c, 43d are inserted in the penetration holes 31b, 31c, 31d, the interface connector 40 is positioned on the printed wiring board 30. The penetration holes 31b, 31c, 31d are holes that penetrate through the upper surface 30A and the lower surface 30B of the printed wiring board 30, and are formed as non plating through holes in this case. The interface connector 40 according to the present embodiment is a USB Type-C connector. However, the type of the interface connector 40 is not particularly limited as long as the interface connector has a non-watertight structure. For example, other interface connectors such as a USB Type-A connector and an HDMI (registered trademark) connector may also be used. Because the interface connector 40 has a non-watertight structure, even if water enters the interface connector 40 through the opening part 73, water does not stay inside the interface connector 40 as long as the amount of water is small, and water is discharged outside the interface connector 40.

### (Electronic Component 50)

The electronic components 50, which are surface mounted components such as an IC chip and a capacitor, are mounted on the second region 30b side of the upper surface 30A of the printed wiring board 30. As shown in FIG. 7, in the present embodiment, a plurality of electronic components 50 are mounted. The electronic components 50 according to the present embodiment are electronic components that are of a different type from the interface connector 40 and the rear connector 91 described later. The number of electronic components 50 on the printed wiring board 30 is not limited to two or more. Furthermore, as described later, in the present embodiment, the first region 30a side inside the case 70 is a non-waterproof region, and the second region 30b side is a waterproof region. Accordingly, the electronic components 50 according to the present embodiment may include an electronic component that requires better waterproof measure than the interface connector 40. Additionally, in the case where the connector unit 100 of the present embodiment can be implemented without the electronic components 50, the electronic components 50 do not necessarily have to be mounted.

### (Waterproof Sealing Member 60)

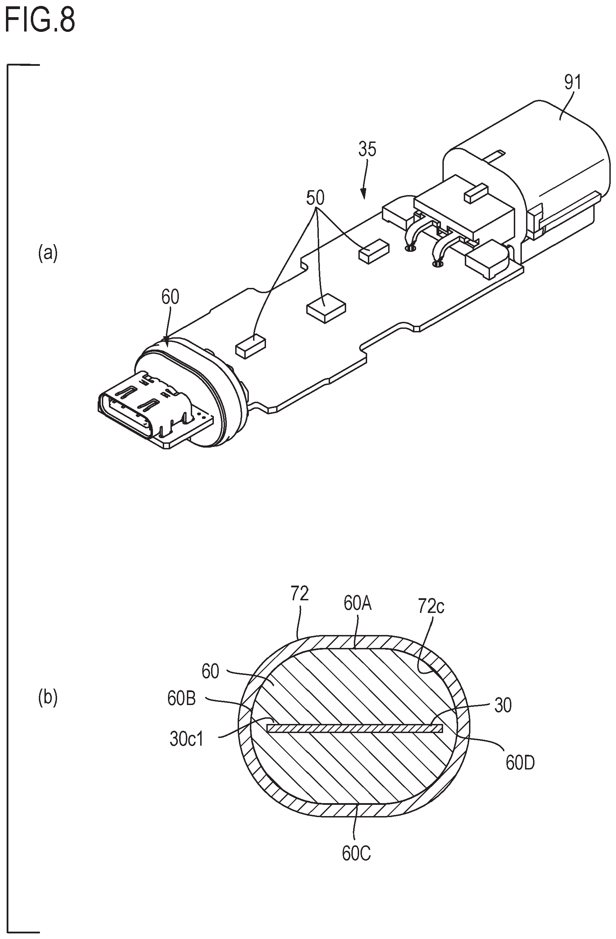

The waterproof sealing member 60 made of a hot melt material is formed on the printed wiring board 30, on an outer circumference 30c1 of the boundary 30c. FIG. 8 is a diagram showing the printed circuit board 35 where the waterproof sealing member 60 is integrally formed. (a) is a perspective view. (b) is a cross-sectional view seen from an interface connector 40 side, where the cross-sectional view is taken along a surface including the boundary 30c shown in (a) of FIG. 7.

As shown in FIG. 8, the waterproof sealing member 60 is integrally formed with the printed wiring board 30 by being in close contact with the printed wiring board 30 while covering the outer circumference 30c1 of the boundary 30c of the printed wiring board 30. As shown in (b) of FIG. 8, the waterproof sealing member 60 formed on the printed wiring board 30 includes pressing surfaces 60A, 60B, 60C, 60D that press an inner surface of the cylindrical part 72 at the time of insertion in the case 70. The pressing surface 60A and the pressing surface 60B, the pressing surface 60B and the pressing surface 60C, the pressing surface 60C and the pressing surface 60D, and the pressing surface 60D and the pressing surface 60A are continuous, and a surface that is continuous as a whole is thus formed. The pressing surfaces 60A, 60B, 60C, 60D are disposed in close contact with the inner surface of the cylindrical part 72 by pressing an inner circumference 72c that is an inner circumference of the cylindrical part 72 of the case 70 and that faces the outer circumference 30c1. Due the structure described above of the waterproof sealing member 60, the waterproof sealing member 60 separates the inside of the case 70 into the first region 30a side and the second region 30b side.

Furthermore, the second region 30b side inside the case 70 according to the present embodiment is a waterproof region. As a specific example for realizing the waterproof region, there may be cited injection of the potting resin 130 or provision of the rear connector 91, as described later.

By providing the waterproof sealing member 60, and making the second region 30b side inside the case 70 a waterproof region, waterproof function can be achieved on the second region 30b side not only in a case where water is received through the opening part 73 of the case 70 but also in a case where water is received from a rear end side of the case 70 (a side of the case 70 opposite from the front plate part 74). Accordingly, the printed wiring board 30 and the electronic components 50 on the second region 30b side inside the case 70 are not affected by water received regardless of the orientation of the connector unit 100 attached to another appliance such as a vehicle.

For example, the waterproof sealing member 60 is integrally formed with the printed wiring board 30 by insert molding. However, the waterproof sealing member 60 does not have to be formed as one member, and may be formed as a plurality of non-annular members that are separately formed from the printed wiring board 30, for example.

### (Case 70)

The printed circuit board 35 where the waterproof sealing member 60 is integrally formed is housed inside the case 70. The case 70 is a molded article formed by thermoplastic resin such as ABS, for example. As described above, the waterproof sealing member 60 separates the inside of the case 70 into the first region 30a side and the second region 30b side. That is, by applying means for achieving the waterproof region described later, inside of the case 70 is divided into a non-waterproof region and a waterproof region across the waterproof sealing member 60.

As shown in FIGS. 2 to 4 and FIG. 6, the case 70 includes cylindrical parts 71, 72, each having a laterally-elongated elliptical cylindrical shape, and the front plate part 74 that is positioned on a front end of the cylindrical part 72. In this example, the front plate part 74 is formed to have a laterally-elongated elliptical shape with an arc shape. In other words, the case 70 includes the front plate part 74 at one end, and the cylindrical parts 71, 72 that protrude from the front plate part 74 toward an other end.

A fixing part 71L is provided on an upper surface side of a front end of the cylindrical part 71. As shown in FIG. 2, the fixing part 71L is formed from bases 71L₁, 71L₂, a coupling platform 71L₃, a projecting part 71L₄, and an engaging part 71Ls. The pair of bases 71L₁, 71L₂ are provided in an upright manner on an upper surface of the cylindrical part 71, and are each a substantially rectangular thin plate that faces the front plate part 74 side and that has a smaller width than the opening part 73. The bases 71L₁, 71L₂ are arranged in the order of the base 71L₁ and the base 71L₂ toward the front plate part 74. The coupling platform 71L₃ is provided in an upright manner while being in contact with the pair of bases 71L₁, 71L₂. The coupling platform 71L₃ reinforces the base 71L₁ and the base 71L₂. The projecting part 71L₄ has a substantially laterally-elongated elliptical cross-section, and protrudes toward the front plate part 74 side from the base 71L₂. The engaging part 71Ls is provided at a tip end of the projecting part 71L₄, and has a substantially laterally-elongated semispherical shape having a cross-section that is slightly larger than the cross-section of the projecting part 71L₄.

The front plate part 74 includes the opening part 73. In the present example, the front plate part 74 includes a pair of groove parts 74K at positions different from the opening part 73. The opening part 73 is an opening part that allows insertion/removal of a mating connector of the interface connector 40. The groove part 74K is a groove that is provided in the front plate part 74, and that is open at least on an outer side of the front plate part 74 (outer side of the case 70). That is, the groove part 74K does not necessarily have to communicate with an inner space of the cylindrical part 72. In the present example, the groove parts 74K are formed by cutting out the front plate part 74 at parts, across the opening part 73, that are somewhat lower than centers of left and right edge parts of the front plate part 74.

A total of six drain hole parts 76 are formed in the cylindrical part 72, or in other words, on the first region 30a side of the case 70, two each in each side surface and a bottom surface. In FIGS. 2 and 4, a subscript numeral is attached to each reference sign to allow identification of each drain hole. The opening part 73 and the drain hole parts 76 each communicate with the inner space of the cylindrical part 72. In the present example, cutout parts 72K are formed from the drain hole parts 76₁, 76₃ to the groove parts 74K. When seen from a side of the cylindrical part 72, due to the groove part 74K and the cutout part 72K, the front plate part 74 side of the drain hole part 76₁, 76₃ is cut out such that a thickness of a side of the case 70 is thinned. According to such a structure, a space (opening part) is formed in the region (the groove part 74K, the cutout part 72K, the drain hole part 76₁, 76₃). Additionally, the connector unit 100 of the present disclosure does not necessarily have to include the cutout part 72K and the groove part 74K. When the waterproof cap 200 is not attached, the groove part 74K and the cutout part 72K achieve a same effect as a cutout part 761 described later. Details of the structure of the drain hole parts 76₁ to 76₄ will be given later.

The printed circuit board 35 where the waterproof sealing member 60 is integrally formed is housed inside the case 70 by being pushed and inserted (press-fitted) into the case 70 from a rear end side of the cylindrical part 71 (a side of the case 70 opposite from the front plate part 74). As shown in (a) of FIG. 4, sliders 71a, 71b, 71c, 71d are formed on an inner surface of the cylindrical part 71, on side surface regions on both left and right sides. In the case of pushing and inserting the printed circuit board 35 where the waterproof sealing member 60 is integrally molded into the case 70, one end part of the printed wiring board 30 in a width direction is inserted between the sliders 71a and 71b, and an other end part is pushed and inserted between the sliders 71c and 71d. Accordingly, as shown in (b) of FIG. 4, the interface connector 40, the electronic components 50, and the waterproof sealing member 60 on the printed wiring board 30, and the rear connector 91 excluding a fitting part 91a are housed together with the printed wiring board 30, at predetermined positions and at predetermined heights inside the case 70.

Inside of the case 70 is separated by the waterproof sealing member 60 into the first region 30a side and the second region 30b side. That is, in the case where the waterproof sealing member 60 is used as the waterproof sealing member, the pressing surfaces 60A, 60B, 60C, 60D of the waterproof sealing member 60 press the inner surface of the cylindrical part 72, as shown in (b) of FIG. 8. The waterproof sealing member 60 thus separates the inside of the case 70 into the first region 30a side and the second region 30b side.

### (Rear Connector 91)

The rear connector 91 to be connected to a harness connector (not shown) is mounted on the upper surface 30A of the printed wiring board 30, on the end part 33 side of the second region 30b. The rear connector 91 is a type of an electronic component. As shown in FIG. 5, the rear connector 91 is configured by a housing 91A, and terminals 92. The housing 91A has a cylindrical shape, and is formed from the fitting part 91a to be fitted with the harness connector mentioned above, and a base part 91b that acts as a lid to a base end of the fitting part 91a. As shown in (a) of FIG. 4, two terminal press-fitted holes 91c are formed in the base part 91b. The rear connector 91 according to the present embodiment includes two terminals 92. The terminal 92 has a shape that is bent into an L-shape, and a pair of protrusions 92a protruding on both sides in a width direction is formed on one side of the L-shape. As shown in FIGS. 4 and 5, the terminal 92 is attached to the housing 91A by having one side of the L-shape press-fitted into the terminal press-fitted hole 91c. The one side of the terminal 92 that is press-fitted is exposed inside the fitting part 91a so as to be connectable to the harness connector mentioned above. An other end of the L-shape of the terminal 92 is inserted and soldered to a through hole 31a provided on the end part 33 side of the printed wiring board 30.

### (Specific Example 1 for Realizing Waterproof Region: Potting Resin 130)

After the waterproof sealing member 60 and the printed circuit board 35 are housed inside the case 70, the potting resin 130 is injected on the second region 30b side inside the case 70. Material of the potting resin 130 may be urethane resin, epoxy resin, or silicone resin, but is not limited thereto. In (b) of FIG. 4, the injected potting resin 130 is shown with a reference sign, and is shown with no patterns and by using no diagonal lines or the like so that the potting resin 130 can be distinguished from the cylindrical part 71 and the printed wiring board 30. As shown in (b) of FIG. 4, injection of the potting resin 130 is performed until the second region 30b side inside the case 70 is filled with the potting resin 130. Due to filling of the potting resin 130, the first region 30a side inside the case 70 can be made a non-waterproof region, and the second region 30b side can be made a waterproof region.

### (Specific Example 2 for Realizing Waterproof Region: Rear Cover 80)

Waterproofness can be achieved by providing the cylindrical part 71 with a rear cover 80, while making the second region 30b side inside the case 70 hollow without injecting the potting resin 130.

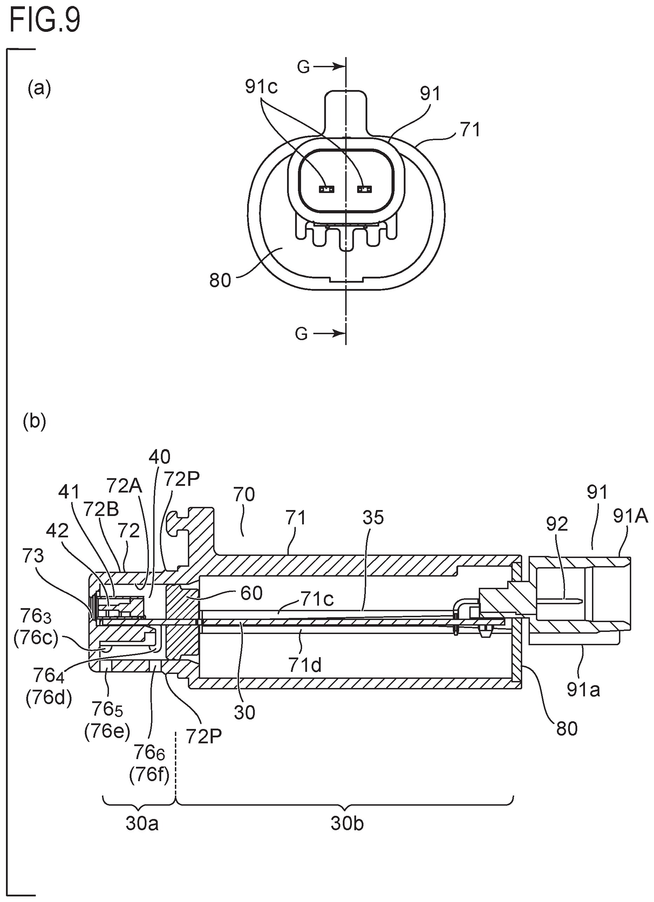

FIG. 9 is a diagram showing an example of the connector unit where the rear cover 80 is included. (a) is a rear view, and (b) is a G-G cross-sectional view of (a). The electronic components 50 are not shown in (b) of FIG. 9. Unlike in FIG. 4, the second region 30b side inside the case 70 of the connector unit 100 shown in FIG. 9 is not filled with the potting resin 130. Instead, a rear end of the cylindrical part 71 inside the case 70, or in other words, an end part on the second region 30b side of the case 70, is covered by the rear cover 80. The rear cover 80 is a laterally-elongated elliptical flat plate having a same shape as an inner diameter of the cylindrical part 71. A contact part between the rear cover 80 and the case 70, or in other words, a part between an inner circumferential surface of a rear end of the cylindrical part 71 and an outer circumferential surface of the rear cover 80, is firmly joined by an adhesive or the like. By covering the rear end of the cylindrical part 71 by the rear cover 80, waterproof function can be achieved on the second region 30b side inside the case 70.

In the case of providing the rear cover 80, the rear cover 80 may be integrally formed between the fitting part 91a and the base part 91b (FIG. 5). The base part 91b thus becomes a part of the rear cover 80, and the fitting part 91a protrudes further rearward from the rear cover 80. Alternatively, the rear cover 80 may be formed as a separate body from the rear connector 91. For example, the rear cover 80 may be structured to hold the rear connector 91. The rear cover 80 may, but does not have to, be formed by a material similar to that of the waterproof sealing member 60.

Also in the case where the second region 30b side inside the case 70 is made a waterproof region by the rear cover 80, the second region 30b side inside the case 70 may be filled with the potting resin 130 to further enhance the waterproof function. Additionally, in the case where the potting resin 130 is not injected, a moisture-proof coating may be applied to the printed wiring board 30 from the standpoint of waterproofness even when the rear cover 80 is provided. As a coating agent, a normal-temperature fluorine coating agent, or a coating agent that uses urethane-based resin, acrylic-based resin, silicone-based resin or the like as a film component can be used.

The rear cover 80 can achieve the waterproof function on the second region 30b side inside the case 70 like the potting resin 130, and can also obtain the waterproof function at a lower cost than the potting resin 130.

### (Water Guide Member 28)

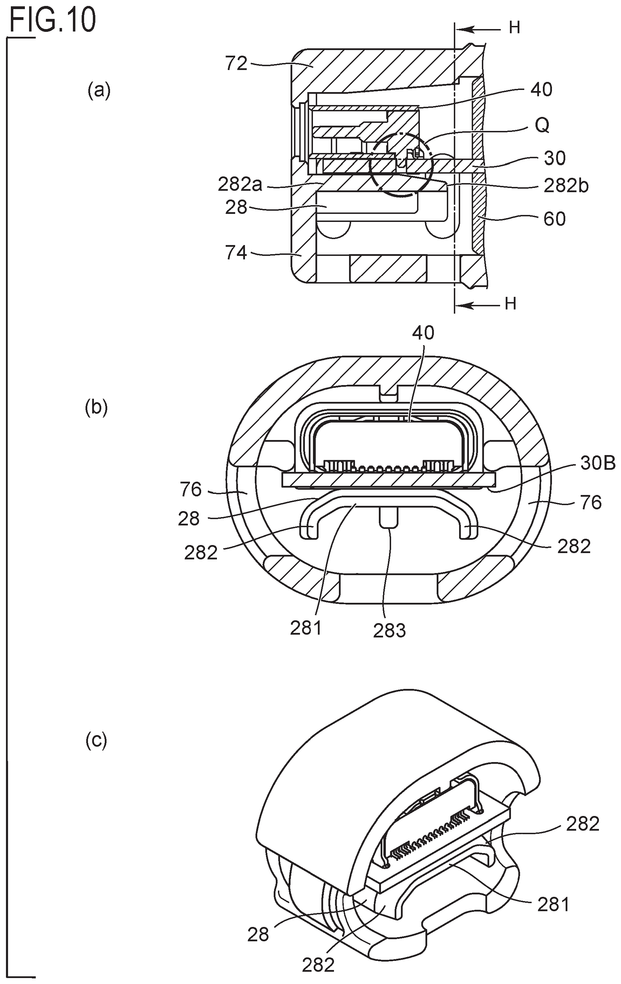

A water guide member 28 is formed in the cylindrical part 72. FIG. 10 is a diagram for describing the water guide member 28. (a) is a diagram showing a part corresponding to the first region 30a of the cylindrical part 72 in a B-B cross-sectional view of (c) of FIG. 2, (b) is an H-H cross-sectional view of (a), and (c) is a perspective view showing (b) from an upper left side. FIG. 11 is an enlarged view of a region Q in (a) of FIG. 10.

The water guide member 28 is formed below the interface connector 40, on the lower surface 30B side of the printed wiring board 30, in a manner protruding toward the waterproof sealing member 60 side with an inner surface of the front plate part 74 as a starting point. The water guide member 28 is formed from a base part 281, two leg parts 282, and a reinforcing part 283. The base part 281 has a flat plate shape that protrudes toward the waterproof sealing member 60 side with the inner surface of the front plate part 74 as a starting point, the flat plate shape being a quadrangular prism with a rectangular bottom surface.

As shown in FIG. 11, when the inner surface of the front plate part 74 is taken as a starting point, a thickness of the base part 281 is constant in a region including a surface 281a, and a region including a surface 281b becomes thinner toward the waterproof sealing member 60 side. That is, the surface 281b is inclined in a direction of separating from the lower surface 30B by an angle θ relative to the surface 281a. The two leg parts 282 extend in a curved manner from end parts of the base part 281 in a lengthwise direction. The base part 281 and the two leg parts 282 are continuous, and form a C-shape as a whole. The base part 281 is positioned with at least a part thereof facing each penetration hole 31b. The leg part 282 has a shape that protrudes from the inner surface of the front plate part 74 toward the waterproof sealing member 60 side by a same length as the base part 281. A thickness of the leg part 282 is constant in a predetermined region corresponding to the surface 281a, but like the base part 281, a region corresponding to the surface 281b becomes thinner toward the waterproof sealing member 60 side. The reinforcing part 283 extends from the inner surface of the front plate part 74 as a starting point toward the waterproof sealing member 60 side, and extends from a center position in the lengthwise direction of the base part 281 in such a way as to reinforce the base part 281. Length of extension is slightly shorter than the base part 281.

As shown in FIG. 11, the water guide member 28 includes an inclined surface (surface 281b) that is at a predetermined angle (90° - θ) from a penetration direction of the penetration hole 31b, and is positioned such that a shortest distance to a center of gravity of the shape of the end part 31b2 (distance X in FIG. 11) is smaller than a radius of a largest circle that can be inserted in the end part 31b2. That is, in the example in FIG. 11, the water guide member 28 is provided at a position where a relationship of X < (D/2) is satisfied. Accordingly, when water that is received protrudes downward from the end part 31b2, the water comes into contact with the water guide member 28. In this case, the base part 281 with the inclined surface and the leg parts 282 become a flow path, and water received that would have stayed in the penetration hole 31b is made to flow downward. Accordingly, the water guide member 28 discharges water that entered the penetration hole 31b of the printed wiring board 30 to outside the printed wiring board 30. A thinned portion of the base part 281, curved portions of the leg parts 282, and thinned portions of the leg parts 282 guide the water received in the directions of respective portions.

The water guide member 28 forms a C-shape by the base part 281 and the leg parts 282, and includes the reinforcing part 283 that reinforces the base part 281. The water guide member 28 is in contact with the inner surface of the front plate part 74. Accordingly, even if a force is applied to the front plate part 74 while a mating connector of the interface connector 40 is being inserted/removed through the opening part 73, deformation or damage to the front plate part 74 is reduced.

### (Drain Hole Part 76, Cutout Part 761)

Six drain hole parts 76 are formed in the cylindrical part 72. On a right side surface of the cylindrical part 72 seen from the front plate part 74 side ((c) of FIG. 2) (hereinafter referred to also as "right side surface of the cylindrical part 72"), a drain hole part 76₁ and a drain hole part 76₂ are formed as a set of drain holes in this order from the front plate part 74 side while being separated from each other by a predetermined distance. On a left side surface of the cylindrical part 72 seen from the front plate part 74 side (hereinafter referred to also as "left side surface of the cylindrical part 72"), a drain hole part 76₃ and a drain hole part 76₄ are formed as a set of drain holes in this order from the front plate part 74 side while being separated from each other by a predetermined distance (FIG. 4). On a bottom surface of the cylindrical part 72 seen from the front plate part 74 side, a drain hole part 76₅ and a drain hole part 76₆ are formed as a set of drain holes in this order from the front plate part 74 side while being separated from each other by a predetermined distance. Each drain hole part 76₁ to 76₆ is formed penetrating from a surface 72A that is an inner surface of the cylindrical part 72 to a surface 72B that is an outer surface. Hole shapes of the drain hole parts 76 that are penetration holes are, in the order of the drain hole parts 76₁ to 76₆, substantially rounded-rectangular hole shapes 76a, 76b, 76c, 76d, 76e, and 76f.

As described later, the cutout part 761 is provided between the drain hole part 76₁ and the drain hole part 76₂, and between the drain hole part 76₃ and the drain hole part 76₄. In the present embodiment, the drain hole parts 76₁ to 76₄ and the two cutout parts 761 are left-right symmetrical with an F-F cross-section shown in (a) of FIG. 4 as a reference surface. A description will be given below of the drain hole parts 76₁, 76₂ and the cutout part 761 provided between the drain hole parts 76₁, 76₂. A description of the drain hole parts 76₃, 76₄, the cutout part 761 provided between the drain hole parts 76₃, 76₄, and the drain hole parts 76₅, 76₆ not including the cutout part 761 will be omitted.

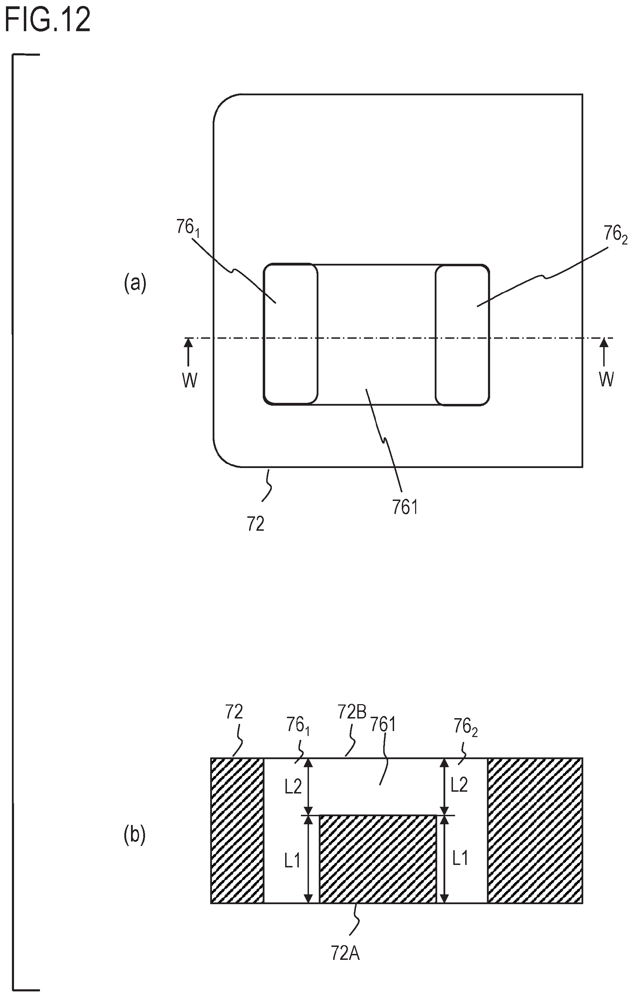

FIG. 12 is a schematic view for describing the drain hole parts 76₁, 76₂ and the cutout part 761 according to the first embodiment. (a) is a side view of a region corresponding to the cylindrical part 72 of the connector unit 100, and (b) is a W-W cross-sectional view of (a). For the sake of convenience, (a) of FIG. 12 does not show the water guide member 28 and the printed wiring board 30 that can be seen from the drain hole part 76₁ and the drain hole part 76₂. In FIG. 12, a structure not including the cutout part 72K and the groove part 74K is shown so as to describe an impact of drainage due to presence of the cutout part 761.

As shown in (b) of FIG. 12, the cutout part 761 having a length L2 is provided between the drain hole part 76₁ and the drain hole part 76₂ that are a set of drain holes. The cutout part 761 has a hole shape that enlarges hole shapes of the drain holes from a mid-point of the drain holes in the penetration direction to an outer surface of the case while being in contact with a part of circumferences of the hole shapes. That is, the cutout part 761 is formed by cutting out the cylindrical part 72 by a length (length L2) from a position, on the drain hole part 76₁ and the drain hole part 76₂, that is separated from the surface 72A by a length L1 to the surface 72B, namely, a mid-point from the inner surface (surface 72A) toward the outer surface (surface 72B) of the cylindrical part 72 in the penetration direction.

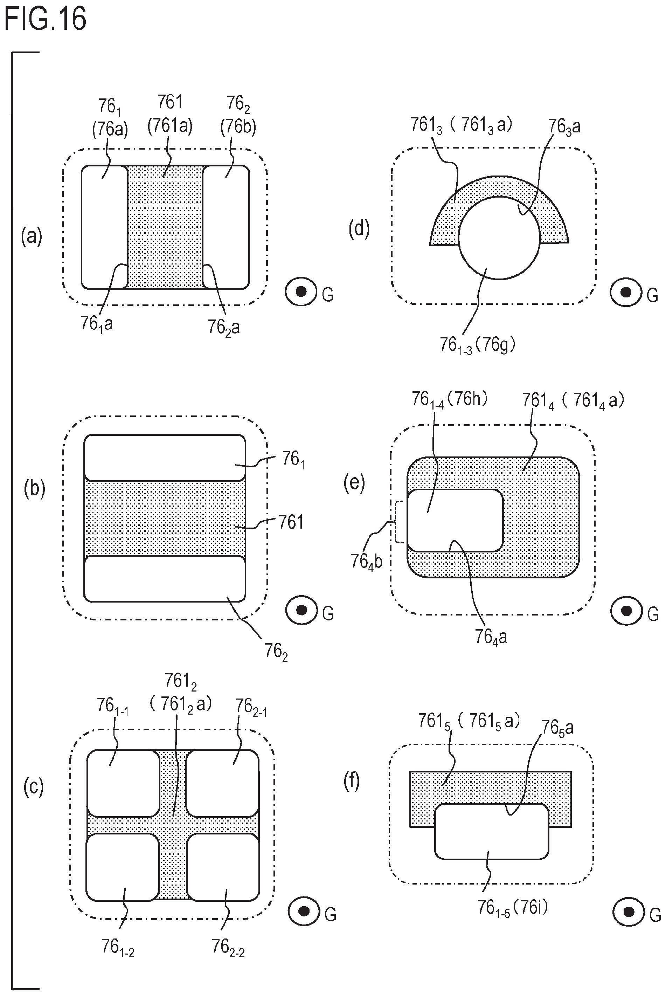

Furthermore, in relation to the drain holes (76₁, 76₂), the cutout part 761 has a substantially rectangular hole shape 761a that enlarges the hole shape 76a and the hole shape 76b while being in contact with end parts 76₁a, 76₂a (see (a) of FIG. 16) that are parts of circumferences of holes at positions separated from the surface 72A by the length L1. That is, the cutout part 761 is formed to cut out the cylindrical part 72 by the length L2 in the penetration direction (penetration direction from the surface 72A to the surface 72B) while having the hole shape 761a, with the end parts 76₁a, 76₂a as a starting point. The cutout part 761 thus has a substantially cuboid space (opening part) having the hole shape 761a.

Due to the cutout part 761 being provided, size and shape of the drain hole part 76₁ and the drain hole part 76₂ are changed from the position at the length L1 (that is, with the end parts 76₁a, 76₂a as a starting point). The drain hole part 76₁ and the drain hole part 76₂ have the shape and size of the hole shapes 76a, 76b until the end parts 76₁a, 76₂a at the distance of the length L1 from the surface 72A. At a part corresponding to the length L2 from the end parts 76₁a, 76₂a to the surface 72B, the drain hole part 76₁ and the drain hole part 76₂ have a shape where three hole shapes, namely, the hole shape 76a, the hole shape 761a, and the hole shape 76b, are connected. That is, hole shapes of the drain hole part 76₁ and the drain hole part 76₂ become discontinuous from the position at the length L1 that is a mid-point in the penetration direction (the end parts 76₁a, 76₂a), and size and shape change as two hole shapes including the hole shapes 76a, 76b change into one hole shape having the size of hole shape 76a + hole shape 761a + hole shape 76b.

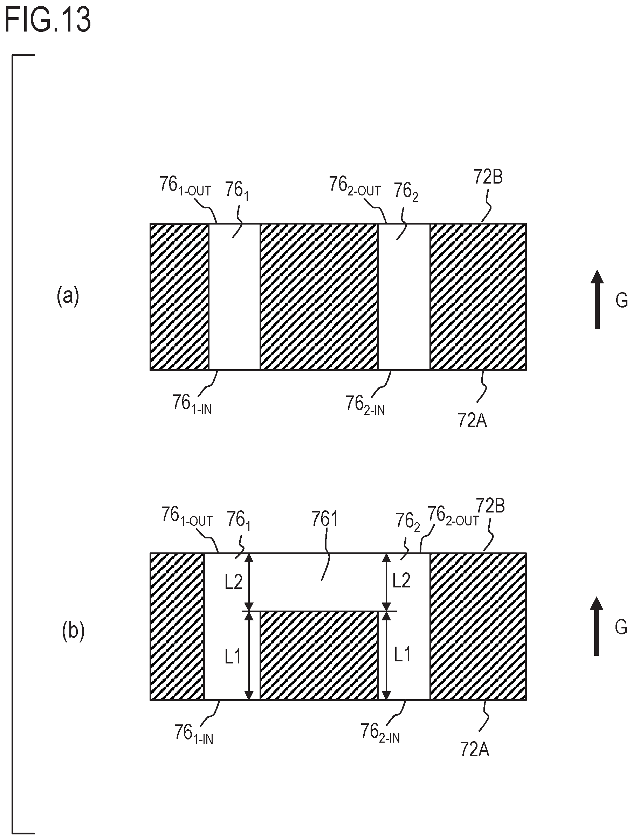

FIG. 13 is a schematic view showing an example of an impact of drainage due to presence of the cutout part 761. (a) is a case where the cutout part 761 is not provided, and (b) is a case where the cutout part 761 is provided. The connector unit 100 is assumed to be used by being attached to a motorcycle or other vehicles, for example, and orientation at the time of use is not necessarily maintained in a state shown in FIG. 2. That is, the connector unit 100 may be used while being oriented in various directions depending on mode of use by the user. The description below is given by assuming an orientation at which drainage is best performed, that is, an orientation at which the penetration direction of the drain hole part 76 and a direction of gravity coincide. A direction of gravity (G) in FIG. 13 is a vertically upward direction when FIG. 13 is seen from front. Openings of the drain hole parts 76₁, 76₂ on the surface 72A side are given as drain hole parts 76_{1-IN}, 76_{2-IN}, and openings on the surface 72B side are given as drain hole parts 76_{1-OUT}, 76_{2-OUT}. Water received through the opening part 73 flows on the printed wiring board 30 via the interface connector 40 and reaches the surface 72A in the cylindrical part 72, or reaches the surface 72A directly from the interface connector 40. Water received reaching the surface 72A partly flows into the drain hole parts 76_{1-IN}, 76_{2-IN}, and flows to the drain hole parts 76_{1-OUT}, 76_{2-OUT}.

In the case where the cutout part 761 is not provided ((a) of FIG. 13), trapping phenomenon may occur, in relation to water received flowing to the drain hole parts 76_{1-OUT}, 76_{2-OUT}, near the drain hole parts 76_{1-OUT}, 76_{2-OUT} that are outlets inside the drain holes. To prevent foreign matters from entering the cylindrical part 72, the connector unit 100 is formed with certain restrictions regarding the shape and size of the drain hole part 76. One cause of the trapping phenomenon is that a sufficiently large hole shape cannot be secured for the drain hole part 76, and water does not become a liquid drop that is large enough to drop.

In the case where the cutout part 761 is provided ((b) of FIG. 13), the size of the hole shape is drastically enlarged from the hole shape 76a or the hole shape 76b to hole shape 76a + hole shape 761a + hole shape 76b beyond the position at the length L1, or in other words, the end parts 76₁a, 76₂a (see (a) of FIG. 16). The drastic change is not made in all circumferential direction of the drain hole, but only in parts of the direction, namely, the end parts 76₁a, 76₂a (see (a) of FIG. 16). In other words, the drain hole parts 76₁, 76₂ are cut out in predetermined ranges around the circumferences of the hole shape 76a and the hole shape 76b. When water received enters the drain hole parts 76_{1-IN}, 76_{2-IN}, a direction of flow from the surface 72A to the surface 72B is maintained, but trapping phenomenon occurs at the end part 76₁a, 76₂a (that is, a circumferential region that is cut out). On the other hand, in a circumferential region that is not cut out side, the drain holes as the drain hole parts 76₁, 76₂ reach the surface 72B, and thus, a flow in the penetration direction is maintained. There is also other water received that flows in at a later timing, and the situation described above is escalated. Accordingly, a direction of a distal end surface of water received near the end part 76₁a, 76₂a is inclined from the penetration direction toward a region that is cut out by a certain angle. In other words, water received that is stuck to a circumference that is not cut out side comes closer to the surface 72B than water received that is stuck to a circumference that is cut out side, and as a result, the direction of the distal end surface of water received near the end part 76₁a, 76₂a tends to be inclined relative to the penetration direction.

Accordingly, with the drain hole parts 76₁, 76₂ where the cutout part 761 is provided, a diameter of a liquid drop that stays near the end parts 76₁a, 76₂a tends to be greater compared to when the cutout part 761 is not provided. When a liquid drop having a greater diameter than when the cutout part 761 is not provided is generated, weight of the liquid drop becomes heavier than in (a) of FIG. 13, and the liquid drop drops easily due to reduced surface tension. Accordingly, the trapping phenomenon can be avoided by providing the cutout part 761. Furthermore, depending on conditions such as the amount of water received entering the drain hole parts 76₁, 76₂ and the speed of flow, a liquid drop of water received from the drain hole part 76₁ and a liquid drop of water received from the drain hole part 76₂ are joined at the cutout part 761 and become a larger liquid drop. In such a case, hole shapes of the drain hole parts 76₁, 76₂ on the surface 72B side are made larger due to the cutout part 761, but the hole shapes on the surface 72A side remain the original sizes of the hole shapes 76a, 76b, and a risk of intrusion of foreign matters is not increased.

As described above, when the cutout part 761 is provided at the drain hole part 76, a diameter of a liquid drop from water received that is retained can be increased and the liquid drop can more easily drop compared to a case where the cutout part is not provided, and thus, water entering the drain hole can be actively discharged inside an appliance without increasing the risk of intrusion of foreign matters into the appliance.

### (Waterproof Cap 200)

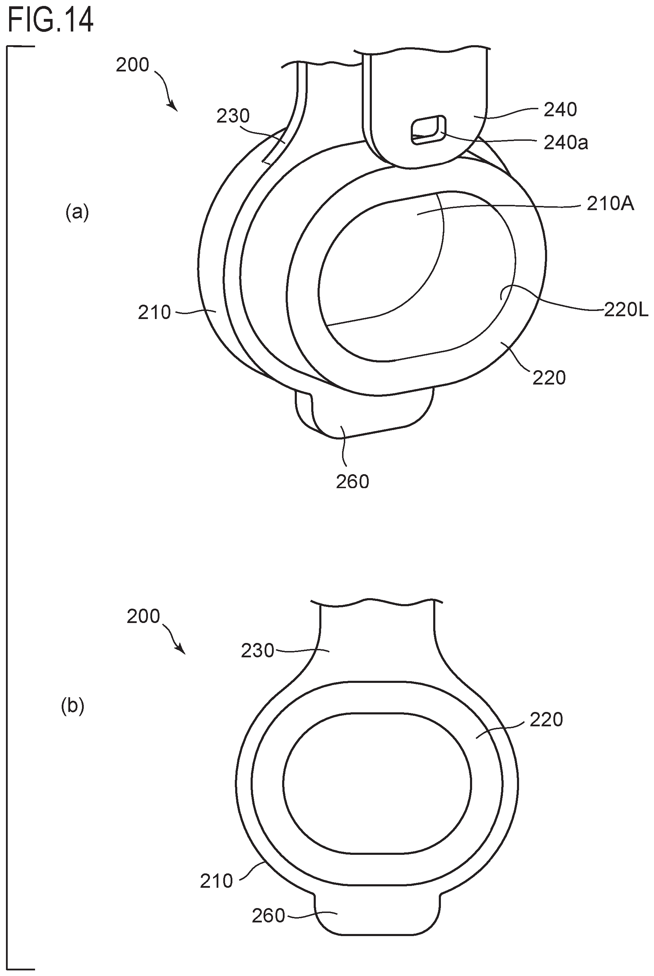

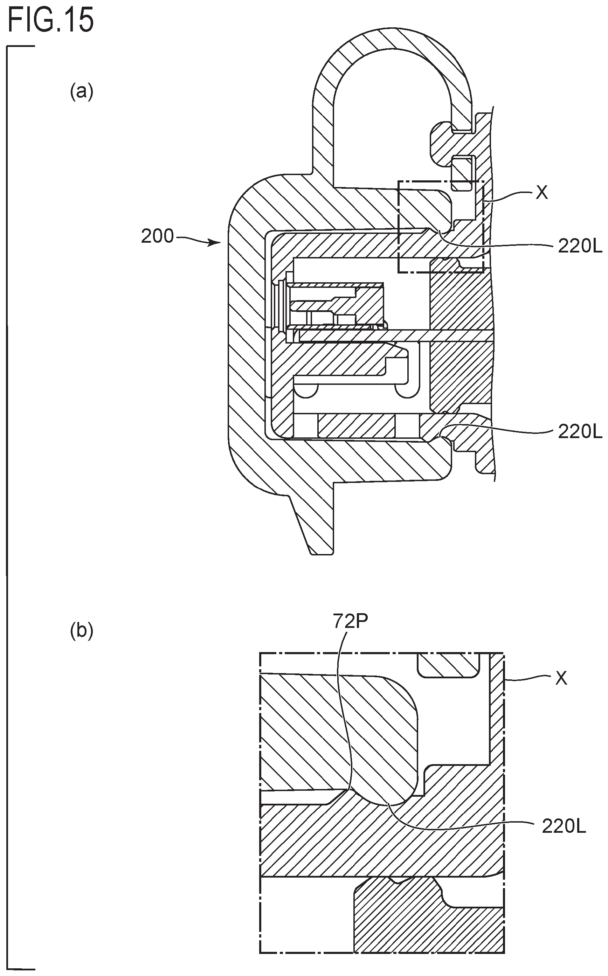

FIG. 14 is a diagram showing a structure of the waterproof cap 200. (a) is a perspective view seen from a peripheral cap 220 side, and (b) is a rear view seen from the peripheral cap 220 side. FIG. 15 is a diagram showing a periphery of the cylindrical part 72 of the connector unit 100 where the waterproof cap 200 is attached. (a) is a diagram showing the waterproof cap 200 in relation to (b) of FIG. 4, and (b) is an enlarged view of a region X in (a).

The waterproof cap 200 includes, as main structural elements, a front cap 210, the peripheral cap 220, a coupling belt 230, a fixing part 240, and an attachment/detachment assist part 260. The waterproof cap 200 is a lid that is unitarily formed in a manner capable of covering the front plate part 74 including the opening part 73 and the groove parts 74K, the cutout parts 72K, the drain hole parts 76, and the cutout parts 761 from outside the front plate part 74 and the cylindrical part 72. For example, the waterproof cap 200 is a molded article formed of thermoplastic elastomer.

The front cap 210 is a lid that mainly covers the front plate part 74 including the opening part 73 and the groove parts 74K, and in the present example, the front cap 210 has a laterally-elongated elliptical shape that is slightly larger than the front plate part 74.

The peripheral cap 220 is a lid that mainly covers the cylindrical part 72 in a circumferential direction. The peripheral cap 220 is continuous from the front cap 210 and protrudes from an inner surface 210A of the front cap 210, and in the present example, the peripheral cap 220 has a hollow cylindrical shape that can almost entirely cover an outer part of the cylindrical part 72, as shown in FIG. 3. The peripheral cap 220 includes a lip part 220L (FIG. 15) having an annular shape near a protruding end part. When the waterproof cap 200 is closed, the lip part 220L engages with an annular protrusion 72P (FIG. 4) provided on the cylindrical part 71 side of the cylindrical part 72 to achieve firmer fastening of the waterproof cap 200 to the case 70, and a waterproof effect and a foreign matter intrusion prevention effect are further increased.

As shown in FIGS. 3 and 6, the coupling belt 230 is a thin plate-shaped belt whose one end is continuous from the front cap 210 and other end is continuous from the fixing part 240. Together with the fixing part 240, the coupling belt 230 serves a chain function of preventing the front cap 210 and the peripheral cap 220 that is continuous from the front cap 210 from coming off the case 70. The coupling belt 230 is elastic enough to be bent 180 degrees or more at the time of attachment of the waterproof cap 200 to the cylindrical part 72.

The fixing part 240 engages with the fixing part 71L, and causes the case 70 and the waterproof cap 200 to be fixed together. The fixing part 240 has a hole part 240a (FIG. 14) that is larger than a cross-sectional shape of the projecting part 71L₄ but slightly smaller than a cross-sectional shape of the engaging part 71Ls so that the fixing part 240 can allow insertion of the engaging part 71Ls through pushing and can be fixed together with the projecting part 71L₄. When the engaging part 71Ls is pushed and inserted in the hole part 240a, the case 70 and the waterproof cap 200 are fixed together.

In the case of covering the cylindrical part 72 and the front plate part 74 by the waterproof cap 200, the inner surface 210A (FIG. 14) of the front cap 210 is caused to face the front plate part 74 from a state where the waterproof cap 200 is fixed to the cylindrical part 71, and the cylindrical part 72 is covered from the front plate part 74 side. The front cap 210 thus covers the opening part 73 and the groove parts 74K. The peripheral cap 220 covers the cutout parts 72K, the drain hole parts 76, and the cutout parts 761 from a circumferential direction of the cylindrical part 72. Foreign matters and water drops can thus be prevented from entering the cylindrical part 72. Accordingly, when the waterproof cap is attached, foreign matters can be prevented from entering the case.

As described above, with the connector unit 100 of the present disclosure, because the cutout part 761 is provided at the drain hole part 76, a diameter of liquid drop from water that is retained can be increased and the liquid drop can more easily drop compared to a case where the cutout part is not provided, and thus, water entering the drain hole can be actively discharged inside an appliance without increasing the risk of intrusion of foreign matters into the appliance. Moreover, the connector unit 100 of the present disclosure includes the waterproof cap 200. Accordingly, intrusion of foreign matters and water drops into the cylindrical part 72 can be prevented. Accordingly, when the waterproof cap is attached, intrusion of foreign matters into the case can be prevented.

### <Modification of First Embodiment>

FIG. 16 is a diagram for describing a drain hole and a cutout part according to a modification of the first embodiment, and (a) is a schematic view showing a periphery of the drain hole part 761 and the drain hole part 762 in (a) of FIG. 12, and (b) to (f) are schematic views showing the drain holes and the cutout parts according to the modification in the same manner as in (a). In FIG. 16, a region corresponding to the cutout part is shown with a dotted line pattern to distinguish between the drain holes and the cutout part. The direction of gravity (G) in FIG. 16 is a vertically forward direction when FIG. 16 is seen from front.

A direction of arrangement of the drain holes of the cylindrical part 72 described above may be a longitudinal direction. For example, as shown in (b) of FIG. 16, the drain hole part 76₁ may be provided in a laterally elongated manner in a right side surface of the cylindrical part 72, the drain hole part 76₂ being provided below (that is, in the longitudinal direction) the drain hole part 76₁ while being separated by a predetermined distance, and the cutout part 761 may be formed in-between. When there are no restrictions on the arrangement direction of the drain holes, there is an advantage that a degree of freedom of design is increased.

A plurality of sets of drain holes may be provided in the cylindrical part 72. For example, as shown in (c) of FIG. 16, two sets of drain holes may be provided, the drain holes being separated from each other by a predetermined distance (drain hole parts 76₁₋₁, 76₂₋₁, and drain hole parts 76₁₋₂, 76₂₋₂), and the sets of drain holes may be separated from each other by a predetermined distance. In this case, a cutout part 761₂ having a hole shape 761₂a having a substantially cross shape is formed between the drain holes. For example, sometimes, to strongly cope with intrusion of foreign matters, only drain holes with a smaller hole shape than the drain hole parts 76₁, 76₂ described above are provided. In this case, by providing a plurality of sets of drain holes as shown in (c) of FIG. 16, and adjusting the number of drain hole parts 76 and the size of the cutout part 761 as appropriate, a stronger measure can be taken against intrusion of foreign matters while achieving a same level of water discharge effect as in (a) of FIG. 16.

The cutout part may be provided for each drain hole. More specifically, a hole shape may be formed for one drain hole, the hole shape being provided from a mid-point in the penetration direction to an outer side of the case while being in contact with at least half of a circumference of the hole shape of the drain hole so as to enlarge the hole shape. For example, as shown in (d) of FIG. 16, in the case where a drain hole part 76₁₋₃ having a hole shape 76g that is a circle is provided, a cutout part 761₃ is formed, the cutout part 761₃ having a hole shape 761₃a that enlarges the hole shape 76g by being in contact with an end part 76₃a that is at least half of a circumference of the drain hole part 76₁₋₃. The cutout part 761₃ is a cutout part just for the drain hole part 76₁₋₃, and is not shared with other drain holes. Accordingly, compared to (a) of FIG. 16, (d) of FIG. 16 has a higher degree of freedom regarding shape and direction of cutout in the cylindrical part 72, and the degree of freedom of design is increased.

In the case where a larger cutout part than in (d) of FIG. 16 can be secured, (e) of FIG. 16 may also be adopted. Another example is shown in (e) of FIG. 16, where a length of the end part 76₃a is at least half of the circumference of the drain hole part 76₁₋₃. As shown in (e) of FIG. 16, a cutout part 761₄ is in contact with an end part 76₄a (three sides and four corner parts of a rounded rectangle) that is most of a circumference of a drain hole part 76₁₋₄ having a hole shape 76h having a rounded-rectangular shape, but is not in contact with an end part 76₄b. The cutout part 761₄ has a hole shape 761₄a that enlarges the hole shape 76h having the rounded-rectangular shape. In the case of (e) of FIG. 16, most of the drain hole part 76₁₋₄ is surrounded by the cutout part 761₄, but a surface of the drain hole part 76₁₋₄, including the end part 76₄b, in the penetration direction is a surface that is continuous from the surface 72A to the surface 72B. Accordingly, water received is not only retained in the cutout part 761₄, but a flow of water in a drainage direction is maintained, and a water dropping effect is achieved.

In the case of a hole shape having a rounded-rectangular shape, the cutout part may be formed to surround and be in contact with at least one side of a circumference of the drain hole part 76 and corner parts at both ends of the one side. For example, as shown in (f) of FIG. 16, a cutout part 761₅ is in contact with an end part 76₅a including one side, in a lengthwise direction, of a drain hole part 76₁₋₅ having a hole shape 76₁ having a rounded-rectangular shape and corner parts on both ends of the one side. The cutout part 761₅ has a hole shape 761₅a. As long as the cutout part 761₅ can have a hole shape that is about the same size or greater than the hole shape 761₅a, the cutout part 761₅ may be formed to be in contact with an end part including one side, in a short direction, of the drain hole part 76₁₋₅ and corner parts on both ends of the one side. Although there is a condition that the hole shape should be rounded-rectangular, it is not necessary for the cutout part to be in contact with at least half of the circumference of the drain hole, and thus, there is an advantage that the degree of freedom of design is higher than in (d) of FIG. 16.

The cutout parts according to the first embodiment and the modification described above each have a hole shape that is formed from a mid-point in the penetration direction (direction from the surface 72A to the surface 72B) to an outer side of the cylindrical part 72 forming the case 70 while being in contact with a predetermined range of the circumference of the hole shape of the drain hole so as to enlarge the hole shape. In other words, the cutout part cuts out a predetermined range of the circumference of the hole shape of the drain hole, from a mid-point in the penetration direction to the outer side of the case 70. Accordingly, compared to a case where the cutout part is not provided, a diameter of a liquid drop formed from retained water received can be increased, and the liquid drop can more easily drop. Accordingly, in each of the first embodiment and the modification thereof, water entering the drain hole can be actively discharged inside an appliance without increasing the risk of intrusion of foreign matters into the appliance.

### <Second Embodiment>

In a second embodiment, the same effect as in the first embodiment is obtained by providing, at a part of the circumference of the drain hole, a projecting part 77 that extends further outward from an outer surface (surface 72B) of the cylindrical part 72, without providing the cutout part.

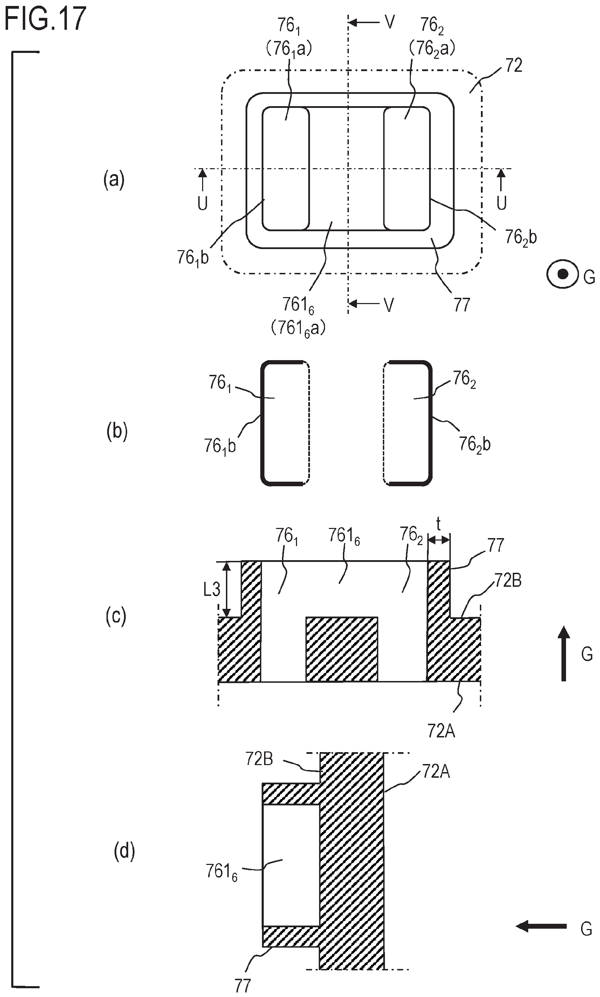

FIG. 17 is a diagram for describing a drain hole and a cutout part according to the second embodiment. (a) is a schematic view shown in the same manner as in (a) of FIG. 16, (b) is a diagram extracting and showing the drain hole parts 761, 762 in (a), (c) is a U-U cross-sectional view of (a), and (d) is a V-V cross-sectional view of (a). As in the first embodiment, the present embodiment includes a set of drain hole parts 76₁, 76₂.

The cylindrical part 72 according to the second embodiment includes the projecting part 77. The projecting part 77 is provided on the outer surface (surface 72B) of the cylindrical part 72 while being continuous from three sides and two corner parts in-between (end parts 76₁b, 76₂b) that are a part of a circumference of each of the drain hole parts 76₁, 76₂, the projecting part 77 surrounding the set of the drain hole parts 76₁, 76₂ and protruding further outward from the surface 72B while having a thickness t. A length of protrusion L3 is adjusted as appropriate by referring to the length L2 (FIG. 13) described above. In (b) of FIG. 17, to clearly show ranges of the end part 76₁b, 76₂b, the drain hole parts 76₁, 76₂ are shown with dotted lines, and the end parts 76₁b, 76₂b are shown with thick lines.

Because the projecting part 77 is provided, the drain hole parts 76₁, 76₂ are further extended outward from the surface 72B. When the drain hole parts 76₁, 76₂ are extended, an opening part 761₆ that is a space having a hole shape 761₆a is formed. That is, two holes, namely, a hole shape 76₁a and a hole shape 76₂a, are formed from the surface 72A to the surface 72B, and one hole shape (hole shape 76₁a + hole shape 761₆a + hole shape 76₂a) is formed beyond the surface 72B. When seen from a different point of view, it can be said that predetermined ranges of circumferences of the hole shapes 76₁a, 76₂a of the drain hole parts 76₁, 76₂ are cut out by the opening part 761₆. Accordingly, the opening part 761₆ achieves a same level of function as the cutout part 761, and water entering the drain hole can be actively discharged inside an appliance without increasing the risk of intrusion of foreign matters into the appliance.

### <Modification of Second Embodiment>

As described above, the opening part 761₆ achieves a same level of function as the cutout part 761. Accordingly, in (a) to (c) of FIG. 16, instead of providing the cutout part, a projecting part may be provided by causing a region corresponding to the cutout part to protrude outward beyond the surface 72B. For example, in the case where the drain hole part 76₁ and the drain hole part 76₂ are provided as shown in (b) of FIG. 16, instead of providing the cutout part 761, a region corresponding to the cutout part 761 may be provided as a projecting part that protrudes outward beyond the surface 72B. Furthermore, in the case where the drain hole parts 76₁₋₁, 76₂₋₁ and the drain hole parts 76₁₋₂, 76₂₋₂ are provided as shown in (c) of FIG. 16, instead of providing the cutout part 761₂, a region corresponding to the cutout part 761₂ may be provided as a projecting part that protrudes outward beyond the surface 72B.

Like the cutout part 761, the projecting part may be provided for each drain hole. Accordingly, in (d) to (f) of FIG. 16, instead of providing the cutout part, a region corresponding to the cutout part may be provided as a projecting part that protrudes outward beyond the surface 72B. For example, in the case where the drain hole part 76₁₋₃ is provided as shown in (d) of FIG. 16, instead of providing the cutout part 761₃, a region corresponding to a predetermined thickness (for example, thickness t) from the end part 76₃a may be provided as a projecting part that protrudes outward beyond the surface 72B. Furthermore, in the case where the drain hole part 76₁₋₄ is provided as shown in (e) of FIG. 16, instead of providing the cutout part 761₄, a region corresponding to a predetermined thickness (for example, thickness t) from the end part 76₄a may be provided as a projecting part that protrudes outward beyond the surface 72B. In the case where the drain hole part 76₁₋₅ is provided as shown in (f) of FIG. 16, instead of providing the cutout part 761₅, a region corresponding to a predetermined thickness (for example, thickness t) from the end part 76₅a may be provided as a projecting part that protrudes outward beyond the surface 72B.

The projecting parts according to the second embodiment and the modification described above are each provided on the outer surface (surface 72B) of the cylindrical part 72 forming the case 70, and the projecting parts each protrude in the penetration direction (direction from the surface 72A to the surface 72B) from the cylindrical part 72 while being in contact with a predetermined range of the circumference of the drain hole. Accordingly, in either of the second embodiment and the modification thereof, water entering the drain hole can be actively discharged inside an appliance without increasing the risk of intrusion of foreign matters into the appliance.

Heretofore, the first embodiment and the modification thereof, and the second embodiment and the modification thereof have been described, but the hole shapes of the drain hole parts 76 are not limited to the shapes described above, and other hole shapes may be adopted. For example, the hole shapes of the drain hole parts 76₁, 76₂, 76₁₋₁, 76₂₋₁, 76₁₋₂, 76₂₋₂, 76₁₋₄ are not limited to be rounded rectangles, and may instead be other shapes such as a circle or an ellipse. The hole shape of the drain hole part 76₁₋₃ is not limited to be a circle, and may instead be other shapes such as a rounded rectangle or an ellipse. The cutout part 761 may be provided between the drain hole parts 76₅ and 76₆ formed in the bottom surface of the cylindrical part 72. It is needless to say that the connector unit 100 described in the present embodiments can be changed as appropriate within the scope of the present invention.

### [DESCRIPTION OF REFERENCE NUMERALS]

28 water guide member
30 printed wiring board
30A upper surface
30a first region
30B lower surface
30b second region
30c boundary
30c1 outer circumference
31a through hole
31b to 31d penetration hole
31b1, 31b2 end part
31bJ axis
32, 33 end part
35 printed circuit board
40 interface connector
41 shell
41a, 41b end part
42 terminal
43b to 43d protruding part
50 electronic component
60 waterproof sealing member
60A to 60D pressing surface
70 case
71, 72 cylindrical part
71a to 71d slider
71L fixing part
71L₁, 71L₂ base
71L₃ coupling platform
71L₄ projecting part
71Ls engaging part
71Ls engaging part
72c inner circumference
72A, 72B surface
72K cutout part
72P annular protrusion part
73 opening part
74 front plate part
74K groove part
76 drain hole part
76₁a to 76₅a end part
76₁b, 76₂b end part
76a to 76i hole shape
761a hole shape
761₂a to 761₆a hole shape
761 cutout part
761₂ to 761₅ cutout part
761₆ opening part
77 projecting part
80 rear cover
91 rear connector
91A housing
91a fitting part
91b base part
91c terminal press-fitted hole
92 terminal
92a protrusion
100 connector unit
130 potting resin
281 base part
281a, 281b surface
282 leg part
282a, 282b surface
283 reinforcing part
200 waterproof cap
210 front cap
210A inner surface
210B outer surface
220 peripheral cap
220L lip part
230 coupling belt
240 fixing part
240a hole part
260 attachment/detachment assist part
D diameter
L1, L2 length
t thickness
X distance

## Claims

1. A connector unit comprising:
a case, an inside of which is separated into a waterproof region and a non-waterproof region;
a metal component mounted in the non-waterproof region of the case;
an opening part provided on a non-waterproof region side of the case, the opening part allowing insertion/removal of a mating connector;
a drain hole part provided on the non-waterproof region side of the case, the drain hole part having a first hole shape penetrating from an inner side to an outer side of the case so as to allow water received in the metal component to be discharged;
a cutout part cutting out a predetermined range of a circumference of the first hole shape of the drain hole, the cutout part extending from a mid-point in a penetration direction to the outer side of the case; and
a waterproof cap that is unitarily formed in a manner capable of covering the opening part, the drain hole part, and the cutout part from outside the case.

2. The connector unit according to Claim 1, wherein the predetermined range of the circumference of the first hole shape corresponding to the cutout part is at least half of the circumference of the first hole shape.

3. The connector unit according to Claim 1, wherein
the first hole shape of the drain hole is a rounded rectangle, and
the predetermined range of the circumference of the first hole shape corresponding to the cutout part is at least one side of a hole shape of the rounded rectangle and corners at both ends of the one side.

4. A connector unit comprising:
a case, an inside of which is separated into a waterproof region and a non-waterproof region;
a metal component mounted in the non-waterproof region of the case;
an opening part provided on a non-waterproof region side of the case, the opening part allowing insertion/removal of a mating connector;
a set of drain hole parts provided on the non-waterproof region side of the case while being separated from each other by a predetermined distance, the drain hole parts each having a first hole shape penetrating from an inner side to an outer side of the case so as to allow water received in the metal component to be discharged;
a cutout part provided between the set of drain holes in the case, the cutout part having a second hole shape that is in contact with a part of a circumference of each of the drain holes from a mid-point in a penetration direction of each of the drain holes to the outer side of the case, and that enlarges the first hole shapes; and
a waterproof cap that is unitarily formed in a manner capable of covering the drain hole parts, the opening part, and the cutout part from outside the case, wherein
the waterproof cap includes a fitting protrusion in a region facing the drain hole part, the fitting protrusion being insertable into the drain hole part.

5. A connector unit comprising:
a case, an inside of which is separated into a waterproof region and a non-waterproof region;
a metal component mounted in the non-waterproof region of the case;
an opening part provided on a non-waterproof region side of the case, the opening part allowing insertion/removal of a mating connector;
a drain hole part provided on the non-waterproof region side of the case, the drain hole part having a first hole shape penetrating from an inner side to an outer side of the case so as to allow water received in the metal component to be discharged;
a projecting part provided on an outer surface of the case, the projecting part being in contact with a predetermined range of a circumference of the first hole shape and protruding in a penetration direction from the case; and
a waterproof cap that is unitarily formed in a manner capable of covering the drain hole part, the opening part, and the projecting part from outside the case.

6. The connector unit according to Claim 5, wherein the predetermined range of the circumference of the first hole shape corresponding to the projecting part is at least half of the circumference of the first hole shape.

7. A connector unit comprising:
a case, an inside of which is separated into a waterproof region and a non-waterproof region;
a metal component mounted in a non-waterproof region of the case;
a set of drain hole parts provided on the non-waterproof region side of the case while being separated from each other by a predetermined distance, the drain hole parts each having a first hole shape penetrating from an inner side to an outer side of the case so as to allow water received in the metal component to be discharged;
a projecting part provided on an outer surface of the case, between the set of drain hole parts, the projecting part being continuous from a part of a circumference of each of the drain hole parts and protruding in a penetration direction from the case; and
a waterproof cap that is unitarily formed in a manner capable of covering the set of drain hole parts and the projecting part from outside the case.

8. The connector unit according to Claim 7, wherein the projecting part is provided on the outer surface of the case in a manner surrounding the set of drain hole parts while being continuous from the part of the circumference of each of the drain hole parts and protruding in the penetration direction from the case.

9. The connector unit according to any one of Claims 1, 2, and 4 to 8, wherein a hole shape of the drain hole part is one of a circle, an ellipse, or a rounded rectangle.
